# EUROPÄISCHE PATENTSCHRIFT

(11) **EP 3 084 903 B1**
(45) Veröffentlichungstag und Bekanntmachung des Hinweises auf die Patenterteilung: **27.01.2021**
(21) Anmeldenummer: 14811822.7
(22) Anmeldetag: 05.12.2014
(51) Int. Cl.: H02B 1/21

(54) **RAHMEN FÜR EINEN SCHALTSCHRANK MIT SCHWENKBAREN HALTERN FÜR VERTEILSAMMELSCHIENEN SOWIE HERSTELLUNGSVERFAHREN FÜR EINEN SCHALTSCHRANK**
FRAMEWORK FOR AN ELECTRICAL CABINET WITH PIVOTABLE HOLDERS FOR DISTRIBUTION BUSBARS AND MANUFACTURING METHOD FOR A CABINET
CHASSIS POUR ARMOIRE ÉLECTRIQUE AVEC DES SUPPORTS PIVOTANTS POUR BARRES OMNIBUS ET PROCÉDÉ DE FABRICATION D'UNE ARMOIRE ÉLECTRIQUE

(30) Priorität: 16.12.2013 DE 102013114105
(43) Veröffentlichungstag der Anmeldung: 26.10.2016
(73) Patentinhaber: Eaton Intelligent Power Limited, Dublin 4 (IE)
(72) Erfinder: SCHERZER, Martin, A-3873 Brand (AT); BERGER, Thomas, A-3910 Zwettl (AT); DOLESCHAL, Guenter, A-3910 Zwettl (AT)
(74) Vertreter: Eaton IP Group EMEA
(86) Internationale Anmeldenummer: PCT/EP2014/076799
(87) Internationale Veröffentlichungsnummer: WO 2015/091039

(56) Entgegenhaltungen:
- EP-A1- 1 143 588
- DE-A1- 19 511 350
- US-A- 2 319 415

## Beschreibung

### TECHNISCHES GEBIET

Die Erfindung betrifft einen Schaltschrank mit einem Rahmen, wobei der Rahmen mehrere miteinander verbundene Rahmenprofile umfasst, die eine im Wesentlichen quaderförmige Außenkontur begrenzen, und wenigstens zwei innerhalb der genannten Außenkontur angeordnete und voneinander vertikal beabstandete Halter, in denen Ausnehmungen angeordnet sind, die einen Teil einer Außenkontur eines gedachten allgemein zylindrischen Körpers bilden, dessen Achse in einer Betriebsposition der Halter vertikal ausgerichtet ist. Die zumindest zwei Halter sind in eine Montageposition bewegbar, in der die genannte Achse schräg zur Vertikalen verläuft. Der Schaltschrank weist auch in Betriebsposition vertikal verlaufende Verteilsammelschienen auf, welche in den zumindest zwei Haltern gelagert sind und die Position der gedachten zylindrischen Körper einnehmen. Schließlich betrifft die Erfindung ein Verfahren zur Herstellung eines Schaltschranks, bei dem ein Rahmen mit mehreren miteinander verbundenen Rahmenprofilen bereitgestellt wird, die eine im Wesentlichen quaderförmige Außenkontur begrenzen, und der wenigstens zwei innerhalb der genannten Außenkontur angeordnete und voneinander vertikal beabstandete Halter aufweist, in denen Ausnehmungen angeordnet sind, die einen Teil einer Außenkontur eines gedachten allgemein zylindrischen Körpers bilden, dessen Achse in einer Betriebsposition der Halter vertikal ausgerichtet ist.

### STAND DER TECHNIK

Ein Schaltschrank und ein Verfahren der genannten Art sind grundsätzlich bekannt. Beispielsweise sind in den zumindest zwei Haltern in der Betriebsposition vertikal verlaufende Verteilsammelschienen gelagert, welche die Position der gedachten zylindrischen Körper einnehmen. Die Verteilsammelschienen können insbesondere mit im Rahmen horizontal verlaufenden Hauptsammelschienen elektrisch verbunden sein und eine zugeführte elektrische Energie an Verbraucher verteilen, die an die Verteilsammelschienen angeschlossen sind.

Die EP 1 143 588 A1 offenbart in diesem Zusammenhang auch einen Ständer für eine elektrische Schalttafel mit einem langgestreckten Körper, der einen ersten Teil aufweist, der so geformt ist, dass er mindestens eine Wand zum Koppeln mit einer Befestigungsführung bildet, und einen zweiten Teil, der so geformt ist, dass die beiden Teile einen Kanal für die Aufnahme elektrischer Leiter bilden.

Die DE 195 11 350 A1 offenbart weiterhin ein Schienenkanalsystem einer Niederspannungs-Schaltanlage mit Stromsammelschienen, die in dem Schienenkanalsystem angeordnet sind und mittels Trägerelementen darin gehaltene Verteilschienen aufweisen, deren elektrische Verbindung zu den Schaltgeräten in der Schaltanlage steckbar ist. Das Schienenkanalsystem weist auch eine am Schienenkanal gehaltene Schottwand zur Abdeckung der Verteilschienen auf, in der mindestens eine Öffnung zum Durchtritt der Kontaktstücke eines Laststromsteckers vorgesehen ist.

Üblicherweise werden die Verteilsammelschienen von der Oberseite des Schaltschranks her eingeschoben. Dies ist jedoch nur möglich, wenn der Raum, in dem der Schaltschrank steht, ausreichend hoch ist. Im Wesentlichen muss dieser doppelt so hoch sein wie der Schaltschrank. Ist dies nicht der Fall, muss der Schaltschrank in eine Position gebracht werden, in der das Einschieben der Verteilsammelschienen möglich ist. Beispielsweise wird der Schaltschrank dazu umgekippt, was aufgrund seines Gewichts vergleichsweise aufwändig ist.

Besonders nachteilig an der vorgestellten Methode ist auch, dass das Einschieben der Verteilsammelschienen nur möglich ist, solange die Hauptsammelschienen nicht in den Schaltschrank eingebaut sind, da diese den Zugang zu den voneinander vertikal beabstandeten Haltern verwehren. Demgemäß wird der Schaltschrank häufig mit so vielen Verteilsammelschienen wie möglich ausgestattet, auch wenn sich nachträglich herausstellen sollte, dass nicht alle diese Verteilsammelschienen benötigt werden. Dementsprechend wird unter Umständen wertvolles Kupfer, aus dem die Verteilsammelschienen üblicherweise bestehen, verschwendet. Werden die Verteilsammelschienen alternativ nach dem Einbau der Hauptsammelschienen in den Schaltschrank eingebaut, so ist dies aber nur sehr umständlich möglich, da hierfür vergleichsweise viele Halter entfernt und wieder montiert werden müssen.

### OFFENBARUNG DER ERFINDUNG

Eine Aufgabe der Erfindung ist es daher, einen verbesserten Schaltschrank sowie ein verbessertes Verfahren zu dessen Herstellung anzugeben. Insbesondere soll die Montage von Verteilsammelschienen vereinfacht beziehungsweise flexibilisiert werden.

Die Aufgabe der Erfindung wird mit einem Schaltschrank der eingangs genannten Art gelöst, bei dem die zumindest zwei Halter durch schwenkbar gelagerte Profile verbunden sind, deren Längsachsen in der Betriebsposition vertikal und in der Montageposition schräg zur Vertikalen ausgerichtet sind.

Die Aufgabe der Erfindung wird weiterhin mit einem Verfahren der eingangs genannten Art gelöst, umfassend die Schritte
- Bewegen der zumindest zwei Halter und Profile in eine Montageposition, in der die genannte Achse schräg zur Vertikalen verläuft, sofern sich diese nicht bereits in der Montageposition befinden,
- Einschieben von Verteilsammelschienen in die Ausnehmungen der Halter und
- Bewegen der zumindest zwei Halter und Profile zurück in eine Betriebsposition.

Durch die vorgeschlagenen Maßnahmen können die Verteilsammelschienen selbst bei bereits montierten Hauptsammelschienen noch in den Rahmen beziehungsweise Schaltschrank eingeschoben werden, ohne dass dazu die Halter der Verteilsammelschienen entfernt und wieder montiert werden müssen. Konkret können die Bewegungen der zumindest zwei Halter durch die vorgeschlagenen Maßnahmen synchronisiert werden. Bei dem vorgestellten Verfahren zur Herstellung eines Schaltschranks werden die zumindest zwei Halter vorteilhaft über die genannten schwenkbar gelagerten Profile in der Betriebsposition fixiert, insbesondere indem sie mit den Rahmenprofilen oder mit einem an diesen befestigten Halter verschraubt werden. Dadurch wird die Herstellung eines Schaltschranks vereinfacht beziehungsweise flexibilisiert, beziehungsweise kann dieser auch später - wenn dieser bereits eingesetzt wird - noch umgebaut werden.

Durch die Bewegung der Halter in eine Montageposition, in der die genannte Achse schräg zur Vertikalen verläuft, können die Verteilsammelschienen zudem auch in vergleichsweise niedrigen Räumen am stehenden Schaltschrank eingebaut werden. durch die Schrägstellung ergibt sich zudem eine ergonomische Arbeitsposition. Auf Leitern und andere Hilfen kann daher in der Regel verzichtet werden.

Ein "allgmeiner Zylinder" ist ein geometrischer Körper, der durch Verschiebung einer ebenen Fläche oder Kurve entlang einer Geraden, die nicht in dieser Ebene liegt, entsteht. Man spricht in diesem Zusammenhang auch von "Extrusion". Die Geraden, welche von der Kante der ebenen Fläche respektive der Kurve in Verschieberichtung wegführen, werden "Erzeugende" bezeichnet. Im Speziellen fallen darunter Zylinder mit kreisförmiger oder polygonförmiger, insbesondere rechteckförmiger oder quadratischer, Grundfläche.

Weitere vorteilhafte Ausgestaltungen und Weiterbildungen der Erfindung ergeben sich aus den Unteransprüchen sowie aus der Beschreibung in Zusammenschau mit den Figuren.

Günstig ist es weiterhin, wenn
- ein erster Querträger mit einem Halter oder den schwenkbar gelagerten Profilen verbunden ist,
- der erste Querträger an einer ersten Deckfläche des gedachten allgemein zylindrischen Körpers angeordnet ist und
- der erste Querträger und die erste Deckfläche einander wenigstens teilweise überlappen.

Dadurch wird der gedachte allgemein zylindrische Körper einseitig begrenzt. Eine an die Stelle des genannten Körpers eingesetzte Verteilsammelschiene wird daher vom ersten Querträger in Bezug auf eine Längsverschiebung in Position gehalten. Günstig ist es darüber hinaus, wenn ein Halter in den ersten Querträger integriert ist, weil dadurch die Anzahl der Bauteile für den Rahmen reduziert werden kann. Günstig ist es zudem, wenn ein zweiter Querträger an der zweiten Deckfläche des gedachten allgemein zylindrischen Körpers angeordnet ist und der zweite Querträger und die zweite Deckfläche einander wenigstens teilweise überlappen. Dadurch wird der gedachte allgemein zylindrische Körper zweiseitig begrenzt. Eine an die Stelle des genannten Körpers eingesetzte Verteilsammelschiene wird daher von den beiden Querträgern in Bezug auf eine Längsverschiebung in beiden Richtungen in Position gehalten.

Günstig ist es auch, wenn die zumindest zwei Halter, die schwenkbar gelagerten Profile oder der erste Querträger Bolzen/Buchsen aufweisen, die in Buchsen/Bolzen der Rahmenprofile schwenkbar gelagert sind. Dadurch kann auf einfache Weise ein Schwenkgelenk für die Halter, Profile oder den ersten Querträger realisiert werden.

Vorteilhaft ist es, wenn der erste Querträger in einem Zustand, in dem Schraubverbindungen zu den Rahmenprofilen gelöst sind, lose an den Rahmenprofilen anliegt und/oder auf diesen aufliegt, jedoch in seinen Freiheitsgraden derart beschränkt ist, dass er relativ zu den Rahmenprofilen maßgeblich nur um seine Längsachse zwischen der Betriebsposition und der Montageposition drehbar ist. Auf diese Weise kann ein Drehgelenk, das im Wesentlichen nur eine Drehung um eine Achse erlaubt und beispielsweise aus einer Kombination aus Buchse und Bolzen besteht, entfallen. Stattdessen liegt der erste Querträger, der in der Betriebsposition mit den Rahmenprofilen verschraubt ist, nach dem Lösen der Schrauben mehr oder minder nur lose an den Rahmenprofilen an und/oder auf diesen auf. Dadurch ist eine Drehung des ersten Querträgers um seine Längsachse und damit eine Drehung des mit dem ersten Querträger verbundenen Halters respektive des mit dem ersten Querträger verbundenen Profilen möglich. Eine maßgebliche Drehung um eine andere Achse und eine maßgebliche Verschiebung wird dagegen durch geeignete Maßnahmen verhindert. Besonders vorteilhaft ist es in diesem Zusammenhang, wenn der erste Querträger in dem genannten Zustand
- zumindest um 10° um seine Längsachse relativ zu den Rahmenprofilen drehbar ist und/oder
- maximal 2° um eine horizontale, auf die Längsachse normal stehende Achse relativ zu den Rahmenprofilen drehbar ist und/oder
- maximal 20 mm relativ zu den Rahmenprofilen verschiebbar ist.

Besonders vorteilhaft ist es weiterhin, wenn der erste Querträger/die Rahmenprofile erste Vorsprünge aufweisen, welche in ersten Ausnehmungen in den Rahmenprofilen/im ersten Querträger gelagert sind und welche die horizontale Bewegung des ersten Querträgers relativ zu den Rahmenprofilen behindern, insbesondere seine horizontale Bewegung quer zu seiner Längsachse. Auf diese Weise wird der erste Querträger hinsichtlich seiner Position (nicht jedoch hinsichtlich seiner Orientierung) mehr oder minder fixiert, wobei eine geringe Verschiebung zugelassen werden kann. Das heißt, dass der erste Querträger zwar nicht nennenswert verschoben, jedoch (um seine Längsachse) gedreht werden kann. Beispielsweise können die genannten Vorsprünge durch Blechlaschen realisiert sein, die in Ausnehmungen (Ausstanzungen) eingreifen.

Besonders vorteilhaft ist es zudem, wenn der erste Querträger und/oder die Rahmenprofile und/oder ein an den Rahmenprofilen angeordnetes Bauteil zweite Vorsprünge aufweisen, welche die Drehung des ersten Querträgers relativ zu den Rahmenprofilen um seine Längsachse behindern. Dadurch kann verhindert werden, dass die Halter für die Verteilsammelschienen übermäßig verschwenkt werden.

Günstig ist es, wenn eine elektrisch isolierende Bodenplatte an einer ersten Deckfläche des gedachten allgemein zylindrischen Körpers angeordnet ist und die Bodenplatte und die erste Deckfläche einander wenigstens teilweise überlappen. Dadurch kann ein Herausfallen der Verteilsammelschienen verhindert und gleichzeitig eine Isolation der Verteilsammelschienen bewirkt werden.

Vorteilhaft ist es, wenn die Bodenplatte in einer mit den Rahmenprofilen verbundenen Halterung, insbesondere im ersten Querträger, lösbar gelagert ist, insbesondere werkzeuglos lösbar. Auf diese Weise kann die Bodenplatte entnommen werden, und die Verteilsammelschienen können somit auch von unten in den Schaltschrankrahmen eingeschoben werden.

Günstig ist es in diesem Zusammenhang, wenn die Bodenplatte im Bereich der quaderförmigen Außenkontur des Rahmens angeordnet ist. Dadurch ist die Bodenplatte leicht zugänglich.

Günstig ist es schließlich, wenn der gedachte allgemein zylindrische Körper als rechteckiges, insbesondere quadratisches, Prisma ausgebildet ist. Dadurch können Verteilsammelschienen aus Flachmaterial in die Ausnehmungen der Halter eingeschoben werden.

### KURZE BESCHREIBUNG DER FIGUREN

Die vorliegende Erfindung wird nachfolgend anhand der in den schematischen Figuren der Zeichnung angegebenen Ausführungsbeispiele näher erläutert. Es zeigen dabei:
- Fig. 1: einen beispielhaften Schaltschrankrahmen beziehungsweise Schaltschrank in Schrägansicht;
- Fig. 2: wie Fig. 1, nur mit nach vorne geschwenkten Verteilsammelschienen;
- Fig. 3: wie Fig. 2, nur mit abgenommener Seitenwand;
- Fig. 4: die Halter, die schwenkbar gelagerten Profile, die Verteilsammelschienen sowie der erste Querträger gesondert dargestellt;
- Fig. 5: eine beispielhaften Schaltschrankrahmen beziehungsweise Schaltschrank mit abnehmbarer isolierender Bodenplatte;
- Fig. 6: den ersten Querträger und die darin montierte isolierende Bodenplatte in Schrägansicht;
- Fig. 7: den ersten Querträger und die isolierende Bodenplatte mit dem Plattenträger in Explosionsdarstellung;
- Fig. 8: ein Detail des beispielhaften Schaltschrankrahmens beziehungsweise Schaltschranks aus Fig. 1;
- Fig. 9: das Detail aus Fig. 8 von unten;
- Fig. 10: das Detail aus Fig. 8 schräg von hinten und
- Fig. 11: das Detail aus Fig. 8 seitlich von hinten.

### DETAILIERTE BESCHREIBUNG DER ERFINDUNG

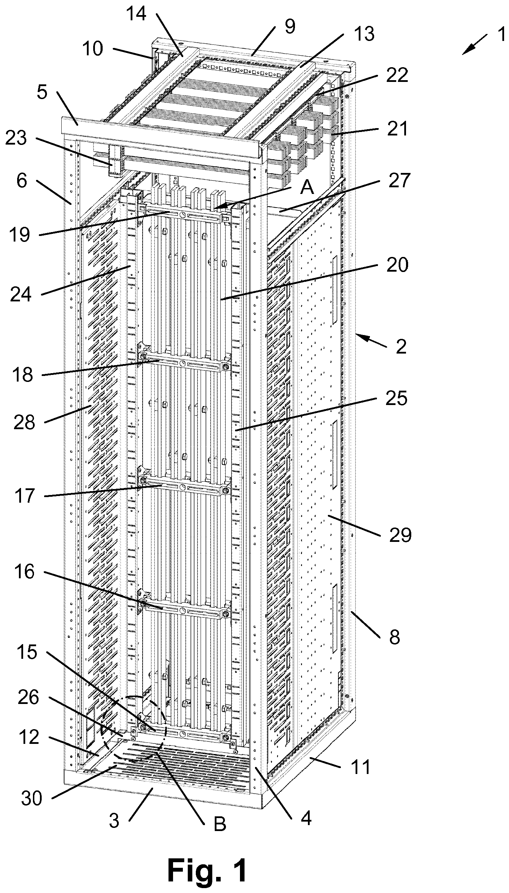

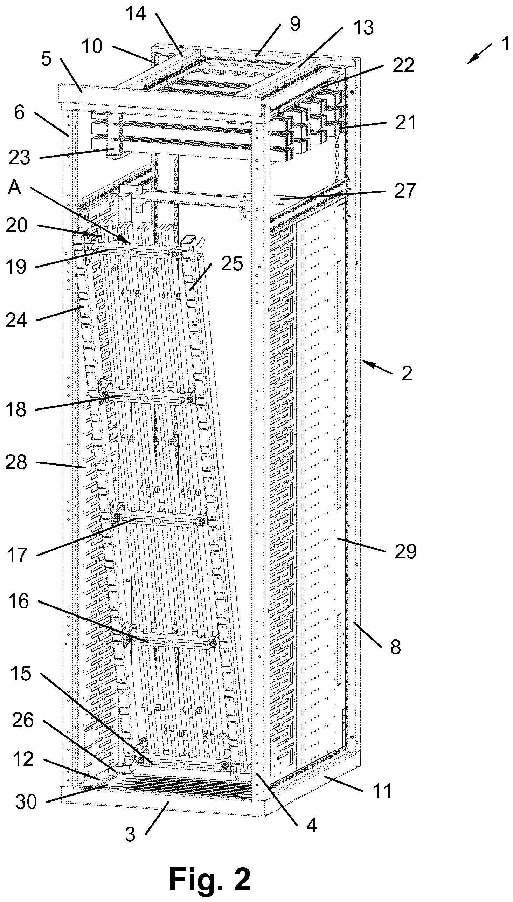

Fig. 1 zeigt einen Schaltschrank 1 mit einem Rahmen 2. Der Rahmen 2 umfasst mehrere miteinander verbundene Rahmenprofile 3..14 , die eine im Wesentlichen quaderförmige Außenkontur begrenzen, wobei das Rahmenprofil 7 in der Fig. 1 verdeckt und daher nicht sichtbar ist. Weiterhin umfasst der Rahmen 2 mehrere innerhalb der genannten Außenkontur angeordnete und voneinander vertikal beabstandete Halter 15..19, in denen Ausnehmungen A angeordnet sind, die einen Teil einer Außenkontur eines gedachten allgemein zylindrischen Körpers bilden, dessen Achse in einer Betriebsposition der Halter 15..19 vertikal ausgerichtet ist. Die Halter 15..19 sind zusätzlich in eine Montageposition bewegbar, in der die genannte Achse schräg zur Vertikalen verläuft, wie dies in der Fig. 2 dargestellt ist.

In dem in Fig. 1 gezeigten Beispiel sind die gedachten allgemein zylindrischen Körper als rechteckige, insbesondere quadratische, Prismen ausgebildet, deren Position durch mehrere Verteilsammelschienen 20 der gleichen Form eingenommen ist. Die Verteilsammelschienen 20 sind in den Haltern 15..19 gelagert und verlaufen in der Betriebsposition vertikal. Die gedachten Körper sind im Rahmen 2 somit gleichsam Platzhalter für die Verteilsammelschienen 20.

In dem gezeigten Beispiel sind die Verteilsammelschienen 20 mit Hauptsammelschienen 21 elektrisch verbunden, die im Rahmen 2 horizontal verlaufen. Die Hauptsammelschienen 21 sind dabei in Haltern 22 und 23 gelagert. Die elektrische Verbindung ist in der Fig. 1 nicht konkret dargestellt. Selbstverständlich sind die Hauptsammelschienen 21 nicht zwingend vorhanden oder horizontal ausgerichtet. Die Verteilsammelschienen 20 können auch auf andere Weise mit einem Stromnetz verbunden sein.

Um die Bewegungen der Halter 15..19 zu synchronisieren, sind diese durch schwenkbar gelagerte Profile 24, 25 verbunden, deren Längsachsen in der Betriebsposition vertikal und in der Montageposition schräg zur Vertikalen ausgerichtet sind.

Der Rahmen 2 weist weiterhin einen ersten Querträger 26 auf, welcher in diesem Beispiel mit den schwenkbar gelagerten Profilen 24, 25 verbunden ist. Alternativ oder zusätzlich kann der erste Querträger 26 auch mit dem Halter 15 verbunden sein. Der erste Querträger 26 ist an einer ersten (unteren) Deckfläche des gedachten allgemein zylindrischen Körpers angeordnet, wobei der erste Querträger 26 quer zu allen gedachten Körpern/Verteilsammelschienen 20 verläuft und damit deren erste Deckfläche bildet respektive mit dieser zusammenfällt. Dadurch wird der gedachte allgemein zylindrische Körper einseitig begrenzt. Eine an die Stelle des genannten Körpers eingesetzte Verteilsammelschiene 20 wird daher vom ersten Querträger 26 in Bezug auf eine Längsverschiebung in Position gehalten. Konkret kann diese im gezeigten Beispiel nicht nach unten hinausfallen.

Der erste Querträger 26 verläuft im dargestellten Beispiel quer zu allen gedachten Körpern/Verteilsammelschienen 20. Dies ist zwar vorteilhaft aber nicht zwingend. An sich ist es ausreichend, wenn der erste Querträger 26 und die erste Deckfläche eines gedachten Körpers / einer Verteilsammelschiene 20 einander wenigstens teilweise überlappen. Denkbar wäre auch, dass der Halter 15 in den ersten Querträger 26 integriert ist, wodurch die Anzahl der Bauteile für den Rahmen 2 beziehungsweise für den Schaltschrank 1 reduziert werden kann.

Denkbar wäre weiterhin, dass ein zweiter Querträger an der zweiten (oberen) Deckfläche des gedachten allgemein zylindrischen Körpers beziehungsweise einer Verteilsammelschiene 20 angeordnet ist und der zweite Querträger und die zweite Deckfläche einander wenigstens teilweise überlappen. Dadurch wird der gedachte allgemein zylindrische Körper zweiseitig begrenzt. Eine an die Stelle des genannten Körpers eingesetzte Verteilsammelschiene 20 wird daher durch die beiden Querträgern in Bezug auf eine Längsverschiebung in beiden Richtungen in Position gehalten.

Die beiden Profile 24, 25 liegen in dem dargestellten Beispiel in der Betriebsposition an einer Querstrebe 27 an und können mit dieser verschraubt werden. Zusätzlich weist der in der Fig. 1 dargestellte Rahmen 2 noch Seitenwände 28, 29 und eine Bodenplatte 30 auf.

Fig. 2 zeigt den Rahmen 2 respektive den Schaltschrank 1 wie bereits erwähnt in der Montageposition.

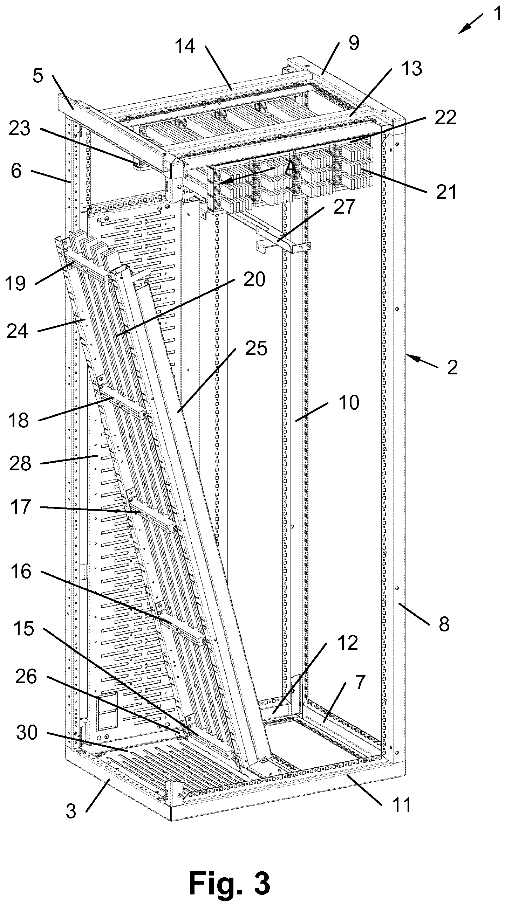

Fig. 3 zeigt den Rahmen 2 respektive den Schaltschrank 1 ebenfalls in der Montageposition, allerdings etwas mehr von der Seite und mit einer abgenommenen Seitenwand 29.

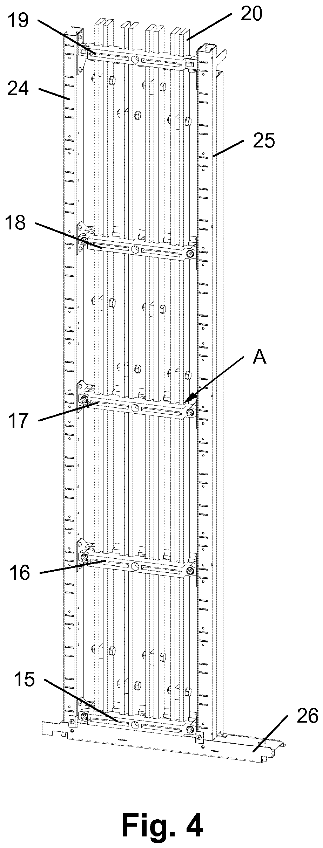

Fig. 4 zeigt die Halter 15..19, die drehbar gelagerten Profile 24, 25, die Verteilsammelschienen 20 sowie den ersten Querträger 26 der besseren Darstellbarkeit halber gesondert dargestellt.

In einem Verfahren zur Herstellung eines Schaltschranks, bei dem ein Rahmen 2 der gezeigten Art bereitgestellt wird, werden nun folgende Schritte ausgeführt:
- Bewegen der Halter 15..19 und der Profile in eine Montageposition, sofern sich diese nicht bereits in der Montageposition befinden (siehe Fig. 2 und 3),
- Einschieben von Verteilsammelschienen 20 in die Ausnehmungen der Halter 15..19 und
- Bewegen der Halter 15..19 und der Profile zurück in eine Betriebsposition (siehe Fig. 1). Insbesondere sind die Halter 15..19 respektive die mit diesen verbundenen, schwenkbar gelagerten Profile 24, 25 in der Betriebsposition fixiert, beispielsweise indem diese mit den Rahmenprofilen 3..14 oder wie hier dargestellt mit der Querstrebe 27 verschraubt werden.

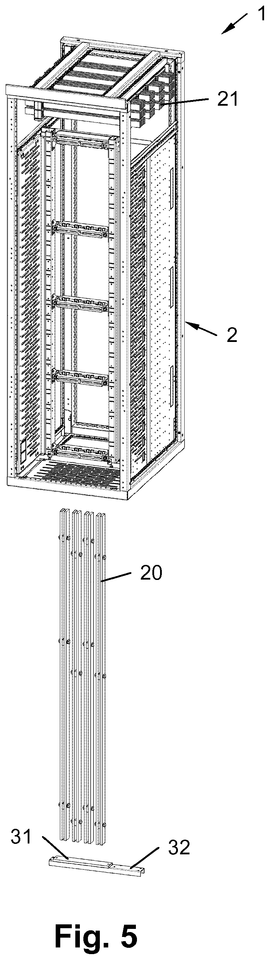

Fig. 5 zeigt nun eine Variante des Rahmens 2 beziehungsweise des Schaltschranks 1, bei der eine elektrisch isolierende Bodenplatte 31 an einer ersten Deckfläche des gedachten allgemein zylindrischen Körpers angeordnet ist. Die Bodenplatte 31 verläuft quer zu allen gedachten Körpern/Verteilsammelschienen 20 und bildet damit deren erste Deckfläche respektive fällt mit diesen zusammen. Dadurch wird der gedachte allgemein zylindrische Körper einseitig begrenzt. Eine an die Stelle des genannten Körpers eingesetzte Verteilsammelschiene 20 wird daher von der Bodenplatte 31 in Bezug auf eine Längsverschiebung in Position gehalten. Konkret kann diese im gezeigten Beispiel wegen der Bodenplatte 31 nicht nach unten hinausfallen.

Die Bodenplatte 31 verläuft im dargestellten Beispiel quer zu allen gedachten Körpern/Verteilsammelschienen 20. Dies ist zwar vorteilhaft aber nicht zwingend. An sich ist es ausreichend, wenn die Bodenplatte 31 und die erste Deckfläche eines gedachten Körpers / einer Verteilsammelschiene 20 einander wenigstens teilweise überlappen. Die Bodenplatte 31 ist in diesem Beispiel im ersten Querträger 26 lösbar gelagert, insbesondere werkzeuglos lösbar. Dies ist zwar vorteilhaft, jedoch nicht zwingend. Ganz allgemein kann die Bodenplatte 31 in einer mit den Rahmenprofilen 3..14 verbundenen Halterung lösbar gelagert sein.

Wie aus der Fig. 5 deutlich wird, können die Verteilsammelschienen 20 nach Lösen der Bodenplatte 31 von unten in den Rahmen 2 eingeschoben werden, auch wenn die Stromsammelschienen 21 bereits montiert sind.

Die in der Fig. 5 offenbarte Variante kann gemeinsam mit den in den Figuren 1 bis 4 offenbarten Maßnahmen angewendet werden. Vorteilhaft ist die Bodenplatte 31 dazu wie dargestellt in den (drehbaren) ersten Querträger 26 eingebaut. Die Verteilsammelschienen 20 können somit durch Lösen der Bodenplatte 31 von unten oder durch Schwenken der in Fig. 4 dargestellten Anordnung nach vorne von oben eingeschoben werden.

In der Fig. 5 ist die isolierende Bodenplatte 31 nicht direkt mit dem ersten Querträger 26 verbunden, sondern indirekt über den Plattenträger 32. Vorteilhaft kann der Plattenträger 32 aus einem tragfähigen Material, beispielsweise aus Metall gefertigt sein, damit dieser die Last der Verteilsammelschienen 20 tragen kann. Die eigentlich isolierende Bodenplatte 31 ist auf diesem Plattenträger 32 montiert und kann daher aus einem weniger tragfähigen Material aufgebaut sein. Selbstverständlich kann die isolierende Bodenplatte 31 aber auch einteilig ausgeführt und direkt mit dem ersten Querträger 26 verbunden sein. Vorteilhaft ist es, wenn die Bodenplatte 31 im Bereich der quaderförmigen Außenkontur des Rahmens 2, hier im Bodenbereich, angeordnet ist.

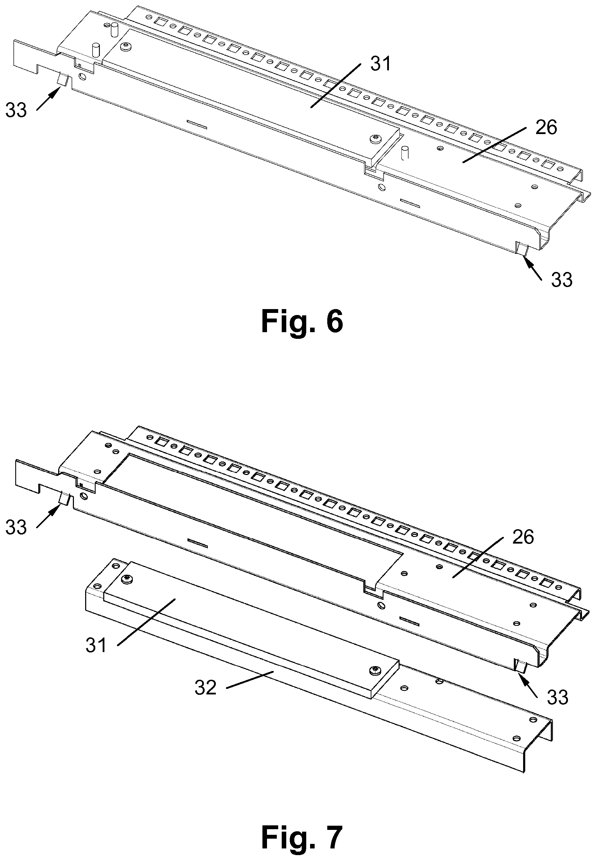

Die Fig. 6 zeigt nun den ersten Querträger 26 und die darin montierte isolierende Bodenplatte 31 in Schrägansicht, die Fig. 7 gemeinsam mit dem Plattenträger 32 in Explosionsdarstellung.

Ein Verfahren zur Herstellung eines Schaltschranks, bei dem ein Rahmen 2 der dargestellten Art bereitgestellt wird, umfasst nun die Schritte:
- Entfernen der an einer ersten Deckfläche des gedachten allgemein zylindrischen Körpers angeordneten elektrisch isolierenden Bodenplatte 31, sofern diese nicht bereits entfernt ist,
- Einschieben von Verteilsammelschienen 20 in die Ausnehmungen der Halter und
- Befestigen der Bodenplatte 31 in der durch den ersten Querträger 26 gebildeten Halterung.

Generell kann das Verschwenken der in Fig. 4 dargestellten Anordnung (siehe Fig. 2 und 3) dadurch erfolgen, dass einer der Halter 15..19, die Profile 24, 25 oder der erste Querträger 26 Bolzen/Buchsen aufweisen, die in Buchsen/Bolzen der Rahmenprofile 3..14 drehbar gelagert sind.

Vorteilhaft ist es jedoch, wenn der erste Querträger 26 in einem Zustand, in dem Schraubverbindungen zu den Rahmenprofilen 3..14 gelöst sind, lose an den Rahmenprofilen 3..14 anliegt und/oder auf diesen aufliegt, jedoch in seinen Freiheitsgraden derart beschränkt ist, dass er relativ zu den Rahmenprofilen 3..14 maßgeblich nur um seine Längsachse zwischen der Betriebsposition und der Montageposition drehbar ist.

Auf diese Weise kann ein Drehgelenk, das im Wesentlichen nur eine Drehung um eine Achse erlaubt und aus einer Kombination aus Buchse und Bolzen besteht, entfallen. Stattdessen liegt der erste Querträger 26, der in der Betriebsposition vorzugsweise mit den Rahmenprofilen 3..14 verschraubt ist, nach dem Lösen der Schrauben mehr oder minder nur lose an den Rahmenprofilen 3..14 an und/oder auf diesen auf. Dadurch ist eine Drehung des ersten Querträgers 26 um seine Längsachse und damit eine Drehung der Anordnung nach Fig. 4 möglich.

Vorzugsweise weist der erste Querträger 26 erste Vorsprünge auf, welche in ersten Ausnehmungen in den Rahmenprofilen 3..14 gelagert sind und welche die horizontale Bewegung des ersten Querträgers 26 relativ zu den Rahmenprofilen 3..14 behindern, insbesondere seine horizontale Bewegung quer zu seiner Längsachse.

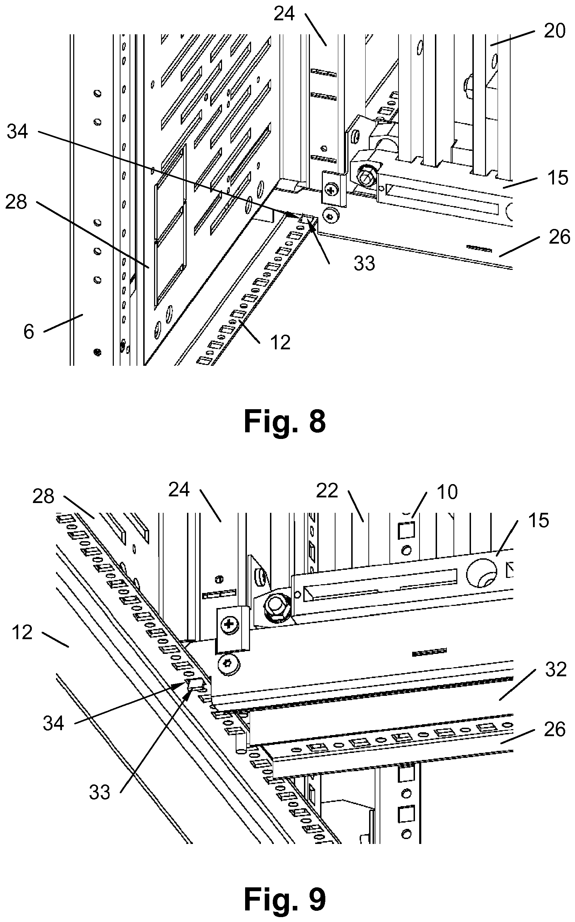

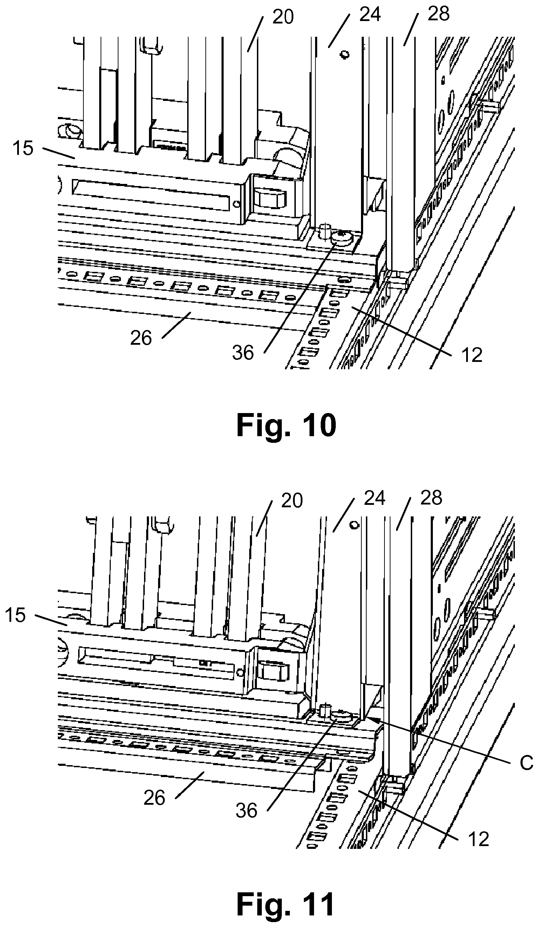

Die Figuren 8 bis 11 zeigen dazu eine beispielhafte konkrete Ausführungsform. Die Fig. 8 zeigt die in Fig. 1 eingetragene Detailansicht B. Die Fig. 9 zeigt dieses Detail schräg von unten, die Fig. 10 schräg von hinten bei vertikalen Stromschienen 20 und die Fig. 11 bei schräg gestellten Stromschienen 20.

Die genannten Vorsprünge sind in diesem Beispiel durch Laschen 33 gebildet (siehe auch die Figuren 6 und 7), welche in Ausnehmungen 34 in den Rahmenprofilen 11 und 12 gelagert sind. Dadurch wird eine Verschiebung des ersten Querträgers 26 stark eingeschränkt. Der erste Querträger 26 kann somit zwar nicht nennenswert verschoben, jedoch um seine Längsachse gedreht werden. Dadurch kann die in Fig. 4 dargestellte Anordnung nach vorne gekippt werden, rutscht jedoch nicht nach hinten weg. Alternativ zu den Laschen 33 im ersten Querträger 26 und den Ausstanzung 34 in den Rahmenprofilen 11, 12 könnten gleichwertig der erste Querträger 26 Ausnehmungen und die Rahmenprofile 11, 12 Laschen aufweisen. Denkbar wäre beispielsweise auch, dass die Vorsprünge durch Bolzen oder Schrauben gebildet sind.

Vorteilhaft weisen der erste Querträger 26 und/oder die Rahmenprofile 3..14 und/oder ein an den Rahmenprofilen 3..14 angeordnetes Bauteil zweite Vorsprünge auf, welche die Drehung des ersten Querträgers 26 relativ zu den Rahmenprofilen 3..14 behindern, insbesondere seine Drehung um seine Längsachse. Im gezeigten Beispiel weisen die Seitenwände 28, 29 Vorsprünge 35 auf, an denen der erste Querträger 26 zur Anlage kommt, wenn die in Fig. 4 dargestellte Anordnung nach vorne gekippt wird. Auf diese Weise wird die Schwenkbewegung der genannten Anordnung begrenzt. Fig. 11 zeigt dazu einen Zustand in dem die in Fig. 4 dargestellte Anordnung aus der Betriebsposition in die Montageposition geschwenkt wurde und der erste Querträger 26 am Vorsprung 35 anliegt (siehe die Kontaktstelle C). Ergänzend zeigt Fig. 10 auch eine Schraube 36, mit welche der erste Querträger 26 in seiner Betriebsposition fixiert werden kann.

Vorteilhaft ist der Rahmen mit Hilfe der gezeigten Maßnahmen so gestaltet, dass der erste Querträger 26 in einem Zustand, in dem Schraubverbindungen 36 zu den Rahmenprofilen 11, 12 gelöst sind,
- zumindest um 10° um seine Längsachse relativ zu den Rahmenprofilen 3..14 drehbar ist und/oder
- maximal 2° um eine horizontale, auf die Längsachse normal stehende Achse relativ zu den Rahmenprofilen 3..14 drehbar ist und/oder
- maximal 20 mm relativ zu den Rahmenprofilen 3..14 verschiebbar ist.

Abschließend wird angemerkt, dass der Rahmen 2 respektive der Schaltschrank 1 nicht notwendigerweise maßstäblich dargestellt sind und daher auch andere Proportionen aufweisen kann. Weiterhin können der Rahmen 2 / der Schaltschrank 1 auch mehr oder weniger Bauteile als dargestellt umfassen. Lageangaben (z.B. "oben", "unten", "links", "rechts", etc.) sind auf die jeweils beschriebene Figur bezogen und sind bei einer Lageänderung des Rahmens 2 / des Schaltschranks 1 sinngemäß an die neue Lage anzupassen. Schließlich wird angemerkt, dass sich die obigen Ausgestaltungen und Weiterbildungen der Erfindung auf beliebige Art und Weise kombinieren lassen, wie in den anhängigen Ansprüchen definiert.

## Patentansprüche

1. Schaltschrank (1) mit einem Rahmen (2), wobei der Rahmen (2)
- mehrere miteinander verbundene Rahmenprofile (3..14) umfasst, die eine im Wesentlichen quaderförmige Außenkontur begrenzen, sowie
- wenigstens zwei innerhalb der genannten Außenkontur angeordnete und voneinander vertikal beabstandete Halter (15..19), in denen Ausnehmungen (A) angeordnet sind, die einen Teil einer Außenkontur eines gedachten allgemein zylindrischen Körpers bilden, dessen Achse in einer Betriebsposition der Halter (15..19) vertikal ausgerichtet ist, wobei
der Schaltschrank (1) in Betriebsposition vertikal verlaufende Verteilsammelschienen (20) aufweist, welche in den zumindest zwei Haltern (15..19) gelagert sind und die Position der gedachten zylindrischen Körper einnehmen,
**dadurch gekennzeichnet, dass**
die zumindest zwei Halter (15..19) in eine Montageposition bewegbar sind, in der die genannte Achse schräg zur Vertikalen verläuft und die zumindest zwei Halter (15..19) durch schwenkbar gelagerte Profile (24, 25) verbunden sind, deren Längsachsen in der Betriebsposition vertikal und in der Montageposition schräg zur Vertikalen ausgerichtet sind.

2. Schaltschrank (1) nach Anspruch 1, **dadurch gekennzeichnet, dass**
- ein erster Querträger (26) mit einem Halter (15..19) oder den drehbar gelagerten Profilen (24, 25) verbunden ist,
- der erste Querträger (26) an einer ersten Deckfläche des gedachten allgemein zylindrischen Körpers angeordnet ist und
- der erste Querträger (26) und die erste Deckfläche einander wenigstens teilweise überlappen.

3. Schaltschrank (1) nach Anspruch 2, **dadurch gekennzeichnet, dass** ein Halter (15..19) in den ersten Querträger (26) integriert ist.

4. Schaltschrank (1) nach einem der Ansprüche 1 bis 3, **dadurch gekennzeichnet, dass** ein zweiter Querträger an der zweiten Deckfläche des gedachten allgemein zylindrischen Körpers angeordnet ist und der zweite Querträger und die zweite Deckfläche einander wenigstens teilweise überlappen.

5. Schaltschrank (1) nach einem der Ansprüche 1 bis 4, **dadurch gekennzeichnet, dass** die zumindest zwei Halter (15..19), die schwenkbar gelagerten Profile (24, 25) oder der erste Querträger (26) Bolzen/Buchsen aufweisen, die in Buchsen/Bolzen der Rahmenprofile (3..14) drehbar gelagert sind.

6. Schaltschrank (1) nach einem der Ansprüche 2 bis 4, **dadurch gekennzeichnet, dass** der erste Querträger (26) in einem Zustand, in dem Schraubverbindungen zu den Rahmenprofilen (3..14) gelöst sind, lose an den Rahmenprofilen (3..14) anliegt und/oder auf diesen aufliegt, jedoch in seinen Freiheitsgraden derart beschränkt ist, dass er relativ zu den Rahmenprofilen (3..14) maßgeblich nur um seine Längsachse zwischen der Betriebsposition und der Montageposition drehbar ist.

7. Schaltschrank (1) nach Anspruch 6, **dadurch gekennzeichnet, dass** der erste Querträger (26) in dem genannten Zustand
- zumindest um 10° um seine Längsachse relativ zu den Rahmenprofilen (3..14) drehbar ist und/oder
- maximal 2° um eine horizontale, auf die Längsachse normal stehende Achse relativ zu den Rahmenprofilen (3..14) drehbar ist und/oder
- maximal 20 mm relativ zu den Rahmenprofilen (3..14) verschiebbar ist.

8. Schaltschrank (1) nach Anspruch 6 oder 7, **dadurch gekennzeichnet, dass** der erste Querträger (26) / die Rahmenprofile (3..14) erste Vorsprünge aufweisen, welche in ersten Ausnehmungen in den Rahmenprofilen (3..14) / im ersten Querträger (26) gelagert sind und welche die horizontale Bewegung des ersten Querträgers (26) relativ zu den Rahmenprofilen (3..14) behindern, insbesondere seine horizontale Bewegung quer zu seiner Längsachse.

9. Schaltschrank (1) nach einem der Ansprüche 6 bis 8, **dadurch gekennzeichnet, dass** der erste Querträger (26) und/oder die Rahmenprofile (3.14) und/oder ein an den Rahmenprofilen (3..14) angeordnetes Bauteil (28, 29) zweite Vorsprünge aufweisen, welche die Drehung des ersten Querträgers (26) relativ zu den Rahmenprofilen (3..14) um seine Längsachse behindern.

10. Schaltschrank (1) nach einem der Ansprüche 1 bis 9, **dadurch gekennzeichnet, dass** eine elektrisch isolierende Bodenplatte (31) an einer ersten Deckfläche des gedachten allgemein zylindrischen Körpers angeordnet ist und die Bodenplatte (31) und die erste Deckfläche einander wenigstens teilweise überlappen.

11. Schaltschrank (1) nach Anspruch 10, **dadurch gekennzeichnet, dass** die Bodenplatte (31) in einer mit den Rahmenprofilen (3..14) verbundenen Halterung, insbesondere im ersten Querträger (26), lösbar gelagert ist, insbesondere werkzeuglos lösbar.

12. Schaltschrank nacheinem der Ansprüche 1 bis 11, **gekennzeichnet durch** im Rahmen (2) horizontal verlaufende Hauptsammelschienen (21), welche mit den Verteilsammelschienen (20) elektrisch verbunden sind.

13. Verfahren zur Herstellung eines Schaltschranks (1), bei dem ein Rahmen (2) mit mehreren miteinander verbundenen Rahmenprofilen (3..14) bereitgestellt wird, die eine im Wesentlichen quaderförmige Außenkontur begrenzen, und der wenigstens zwei innerhalb der genannten Außenkontur angeordnete und voneinander vertikal beabstandete Halter (15..19) aufweist, in denen Ausnehmungen angeordnet sind, die einen Teil einer Außenkontur eines gedachten allgemein zylindrischen Körpers bilden, dessen Achse in einer Betriebsposition der Halter (15..19) vertikal ausgerichtet ist, wobei die zumindest zwei Halter (15..19) durch schwenkbar gelagerte Profile (24, 25) verbunden sind, deren Längsachsen in der Betriebsposition vertikal und in der Montageposition schräg zur Vertikalen ausgerichtet sind, **gekennzeichnet durch** die Schritte
- Bewegen der zumindest zwei Halter (15..19) und der schwenkbar gelagerten Profile (24,25) in eine Montageposition, in der die genannte Achse schräg zur Vertikalen verläuft, sofern sich diese nicht bereits in der Montageposition befinden,
- Einschieben von Verteilsammelschienen (20) in die Ausnehmungen der Halter (15..19) und
- Bewegen der zumindest zwei Halter (15..19) und der schwenkbar gelagerten Profile (24, 25) zurück in eine Betriebsposition.

## Claims

1. Switchgear cabinet (1) with a frame (2), wherein the frame (2)
- comprises a plurality of interconnected frame profile elements (3..14), which define an essentially cuboid external contour and
- at least two holders (15..19) arranged inside said external contour and spaced apart from one another vertically, in which holders recesses (A) are arranged, which form part of an external contour of an intended generally cylindrical body, the axis of which is aligned vertically in an operating position of the holders (15..19), wherein
the switchgear cabinet (1) in operating position has vertically running distributor busbars (20) which are mounted in the at least two holders (15..19) and adopt the position of the intended cylindrical body,
**characterised in that**
the at least two holders (15..19) can be moved into an assembly position, in which said axis runs at an angle to the vertical and the at least two holders (15..19) are connected by pivotably mounted profiles (24, 25), the longitudinal axes of which are aligned in operating position vertically and in the assembled position at an angle to the vertical.

2. Switchgear cabinet (1) according to claim 1, **characterised in that**
- a first cross member (26) is connected to a holder (15..19) or the rotatably mounted profiles (24, 25),
- the first cross member (26) is arranged on a first cover face of the intended generally cylindrical body and
- the first cross member (26) and the first cover face overlap one another at least partly.

3. Switchgear cabinet (1) according to claim 2, **characterised in that** a holder (15..19) is integrated into the first cross member (26).

4. Switchgear cabinet (1) according to any of claims 1 to 3, **characterised in that** a second cross member is arranged on the second cover face of the intended generally cylindrical body and the second cross member and the second cover face overlap one another at least partly.

5. Switchgear cabinet (1) according to any of claims 1 to 4, **characterised in that** the at least two holders (15..19), the pivotably mounted profiles (24, 25) or the first cross member (26) have bolts/bushings, which are mounted rotatably in bushings/bolts of the frame profile elements (3..14).

6. Switchgear cabinet (1) according to any of claims 2 to 4, **characterised in that** the first cross member (26) in a state, in which screw connections with the frame profile elements (3..14) are loosened, bears and/or lies loosely on the frame profile elements (3..14), but is limited in its degrees of freedom such that relative to the frame profile elements (3..14) it is rotatable largely only about its longitudinal axis between the operating position and the assembly position.

7. Switchgear cabinet (1) according to claim 6, **characterised in that** the first cross member (26) in said state
- is rotatable by at least 10° about its longitudinal axis relative to the frame profile elements (3..14) and/or
- is rotatable by a maximum of 2° about a horizontal axis, normal to the longitudinal axis relative to the frame profile elements (3..14) and/or
- is displaceable by a maximum of 20 mm relative to the frame profile elements (3..14).

8. Switchgear cabinet (1) according to claim 6 or 7, **characterised in that** the first cross member (26) / the frame profile elements (3..14) have first projections, which are mounted in first recesses in the frame profile elements (3..14) / in the first cross member (26) and which prevent the horizontal movement of the first cross member (26) relative to the frame profile elements (3..14), in particular its horizontal movement perpendicular to its longitudinal axis.

9. Switchgear cabinet (1) according to any of claims 6 to 8, **characterised in that** the first cross member (26) and/or the frame profile elements (3.14) and/or a component (28, 29) arranged on the frame profile elements (3..14) have second projections which prevent the rotation of the first cross member (26) relative to the frame profile elements (3..14) about its longitudinal axis.

10. Switchgear cabinet (1) according to any of claims 1 to 9, **characterised in that** an electrically insulating base plate (31) is arranged on a first cover face of the intended generally cylindrical body and the base plate (31) and the first cover face overlap one another at least partly.

11. Switchgear cabinet (1) according to claim 10, **characterised in that** the base plate (31) is mounted releasably in a holder connected to the frame profile elements (3..14), in particular in the first cross member (26), in particular is releasable without tools.

12. Switchgear cabinet according to any of claims 1 to 11, **characterised by** main busbars (21) running horizontally in the frame (2), which are electrically connected to the distributor busbars (20).

13. Method for producing a switchgear cabinet (1), wherein a frame (2) is provided with a plurality of interconnected frame profile elements (3..14), which define an essentially cuboid external contour, and which has at least two holders (15..19) arranged inside the said external contour and spaced apart from one another vertically, in which recesses are arranged which form part of an external contour of an intended generally cylindrical body, the axis of which is aligned vertically in an operating position of the holders (15..19), wherein the at least two holders (15..19) are connected by pivotably mounted profiles (24, 25), the longitudinal axes of which are aligned vertically in operating position and at an angle to the vertical in the assembly position,
**characterised by** the steps
- moving the at least two holders (15..19) and the pivotably mounted profiles (24, 25) into an assembly position in which the said axis runs at an angle to the vertical, provided that the latter are not already in the assembly position,
- inserting distributor busbars (20) into the recesses of the holders (15..19) and
- moving the at least two holders (15..19) and the pivotably mounted profiles (24, 25) back into an operating position.

## Revendications

1. Armoire de commutation (1) avec un cadre (2), dans laquelle le cadre (2)
- comprend plusieurs profilés de cadre interconnectés (3..14) qui délimitent un contour extérieur sensiblement parallélépipédique, et
- au moins deux supports (15..19) disposés à l'intérieur dudit contour extérieur et espacés verticalement l'un de l'autre, dans lesquels sont disposés des évidements (A) qui font partie d'un contour extérieur d'un corps imaginaire généralement cylindrique, dont l'axe est aligné verticalement dans une position de fonctionnement des supports (15..19), dans lequel
l'armoire de commutation (1) présente des barres omnibus de distribution (20) qui, en position de fonctionnement, sont disposées verticalement et montées dans les au moins deux supports (15..19) et prennent la position des corps cylindriques imaginaires,
**caractérisée en ce que** les au moins deux supports (15..19) peuvent être déplacés dans une position de montage dans laquelle ledit axe s'étend en biais par rapport à la verticale, et les au moins deux supports (15..19) sont reliés par des profilés (24, 25) montés de manière pivotante dont les axes longitudinaux sont alignés verticalement en position de fonctionnement et en biais par rapport à la verticale en position de montage.

2. Armoire de commutation (1) selon la revendication 1, **caractérisée**
- **en ce qu'**une première traverse (26) est reliée à un support (15..19) ou aux profilés (24, 25) montés de manière rotative,
- **en ce que** la première traverse (26) est disposée sur une première surface de recouvrement du corps imaginaire généralement cylindrique, et
- **en ce que** la première traverse (26) et la première surface de recouvrement se chevauchent au moins partiellement.

3. Armoire de commutation (1) selon la revendication 2, **caractérisée en ce qu'**un support (15..19) est intégré dans la première traverse (26).

4. Armoire de commutation (1) selon l'une quelconque des revendications 1 à 3, **caractérisée en ce qu'**une seconde traverse est disposée sur la seconde surface de recouvrement du corps imaginaire généralement cylindrique et la seconde traverse et la seconde surface de recouvrement se chevauchent au moins partiellement.

5. Armoire de commutation (1) selon l'une quelconque des revendications 1 à 4, **caractérisée en ce que** les au moins deux supports (15..19), les profilés (24, 25) montés de manière pivotante ou la première traverse (26) présentent des boulons/douilles qui sont montés de manière rotative dans des douilles/boulons des profilés de cadre (3..14).

6. Armoire de commutation (1) selon l'une quelconque des revendications 2 à 4, **caractérisée en ce que** la première traverse (26), dans un état dans lequel des raccords à vis sont desserrés des profilés de cadre (3..14), repose de manière desserrée sur les profilés de cadre (3..14) et/ou repose sur ces derniers, mais est limitée dans ses degrés de liberté de sorte qu'elle ne peut tourner de manière décisive par rapport aux profilés de cadre (3..14) qu'autour de son axe longitudinal entre la position de fonctionnement et la position de montage.

7. Armoire de commutation (1) selon la revendication 6, **caractérisée en ce que** la première traverse (26) dans ledit état
- peut tourner d'au moins 10° autour de son axe longitudinal par rapport aux profilés de cadre (3..14) et/ou
- peut tourner de 2° maximum autour d'un axe horizontal normal sur l'axe longitudinal par rapport aux profilés de cadre (3..14) et/ou
- peut être déplacé de 20 mm maximum par rapport aux profilés de cadre (3..14).

8. Armoire de commutation (1) selon la revendication 6 ou 7, **caractérisée en ce que** la première traverse (26)/les profilés de cadre (3..14) présentent de premières saillies qui sont montées dans de premiers évidements dans les profilés de cadre (3..14)/dans la première traverse (26) et qui empêchent le mouvement horizontal de la première traverse (26) par rapport aux profilés de cadre (3..14), en particulier son mouvement horizontal transversalement à son axe longitudinal.

9. Armoire de commutation (1) selon l'une quelconque des revendications 6 à 8, **caractérisée en ce que** la première traverse (26) et/ou les profilés de cadre (3..14) et/ou un composant (28, 29) disposé sur les profilés de cadre (3..14) présentent de secondes saillies qui empêchent la rotation de la première traverse (26) par rapport aux profilés de cadre (3..14) autour de son axe longitudinal.

10. Armoire de commutation (1) selon l'une quelconque des revendications 1 à 9, **caractérisée en ce qu'**une plaque de fond (31) électriquement isolante est disposée sur une première surface de recouvrement du corps imaginaire généralement cylindrique et la plaque de fond (31) et la première surface de recouvrement se chevauchent au moins partiellement.

11. Armoire de commutation (1) selon la revendication 10, **caractérisée en ce que** la plaque de fond (31) est montée de manière amovible, en particulier de manière amovible sans outil, dans une fixation reliée aux profilés de cadre (3..14), en particulier dans la première traverse (26).

12. Armoire de commutation selon l'une quelconque des revendications 1 à 11, **caractérisée par** des barres omnibus principales (21) qui s'étendent horizontalement dans le cadre (2) et sont reliées électriquement aux barres omnibus de distribution (20).

13. Procédé de fabrication d'une armoire de commutation (1), dans lequel un cadre (2) est doté de plusieurs profilés de cadre (3..14) reliés entre eux, qui délimitent un contour extérieur sensiblement parallélépipédique, et qui présente au moins deux supports (15..19) dans lesquels sont disposés des évidements qui font partie d'un contour extérieur d'un corps imaginaire généralement cylindrique dont l'axe est orienté verticalement dans une position de fonctionnement des supports (15..19), dans lesquels les au moins deux supports (15..19) sont reliés par des profilés (24, 25) montés de manière pivotante, dont les axes longitudinaux sont orientés verticalement dans la position de fonctionnement et en biais par rapport à la verticale dans la position de montage, **caractérisé par** les étapes consistant à
- déplacer les au moins deux supports (15..19) et les profilés (24, 25) montés de manière pivotante dans une position de montage dans laquelle ledit axe s'étend en biais par rapport à la verticale, s'ils ne se trouvent pas déjà en position de montage,
- insérer des barres omnibus de distribution (20) dans les évidements des supports (15..19) et
- remettre les au moins deux supports (15..19) et les profilés (24, 25) montés de manière pivotante dans une position de fonctionnement.
